(19) Europäisches Patentamt
European Patent Office
Office européen des brevets

(11) Publication number : **0 573 053 B1**

(12) # EUROPEAN PATENT SPECIFICATION

(45) Date of publication of patent specification : **18.10.95 Bulletin 95/42**

(51) Int. Cl.$^6$ : **G03F 7/038,** G03F 7/027

(21) Application number : **93108973.4**

(22) Date of filing : **04.06.93**

(54) **Photo-curable and thermosetting coating composition and method for formation of solder resist pattern.**

(30) Priority : **05.06.92 JP 169985/92**

(43) Date of publication of application : **08.12.93 Bulletin 93/49**

(45) Publication of the grant of the patent : **18.10.95 Bulletin 95/42**

(84) Designated Contracting States : **DE FR GB IT**

(56) References cited :
**EP-A- 0 323 563**
**EP-A- 0 469 537**
**DE-A- 3 841 422**

(73) Proprietor : **TAIYO INK MANUFACTURING CO. LTD.**
**7-1, Hazawa 2-chome**
**Nerima-ku, Tokyo (JP)**

(72) Inventor : **Saitoh, Teruo**
**793, Magome**
**Iwatsuki-shi, Saitama-ken (JP)**
Inventor : **Nakamura, Shinji**
**No. 202, Haitsu-Sanai,**
**12-13, Minami-cho**
**Saka-do-shi, Saitama-ken (JP)**
Inventor : **Kimura, Norio**
**No. 101, Kopo-Kasahara,**
**1-18-2, Nakahara-cho**
**Kawagoe-shi, Saitama-ken (JP)**
Inventor : **Inagaki, Hitoshi**
**1-10-1, Higashiogawa,**
**Ogawa-machi**
**Hiki-gun, Saitama-ken (JP)**
Inventor : **Suzuki, Morio**
**847-8, Shimohideya**
**Okegawa-shi, Saitama-ken (JP)**
Inventor : **Sawazaki, Kenji**
**3-18-12, Suneori-cho**
**Tsurugashima-shi, Saitama-ken (JP)**

(74) Representative : **Dr. Fuchs, Dr. Luderschmidt**
**Dr. Mehler, Dipl.-Ing Weiss Patentanwälte**
**Postfach 46 60**
**D-65036 Wiesbaden (DE)**

EP 0 573 053 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a novel photo-curable and thermosetting coating composition and more particularly to a coating composition which can be diluted with water and put to use as developed with a dilute aqueous acid solution and, therefore, is useful for the formation of a solder resist pattern on a printed circuit board and suitable especially for the formation of a solder resist pattern on a printed circuit board by means of a spray coater and a curtain coater. This invention further relates to a method for the formation of a solder resist pattern on a printed circuit board by the use of the coating composition mentioned above and to a printed circuit board having a solder resist film formed thereon in a prescribed pattern.

Owing to the recent rapid advance of semiconductor parts, the electronic devices have been showing a growing inclination toward reduction in size and weight, improvement in quality, and enrichment of versatility of performance. As a natural result, the printed circuit boards are tending toward increased density of printed circuits and adoption of surface mount technology of the printed circuit board. In response to such high-density printed circuit boards, the photoimageable solder resists which rely on the photographic process for the formation of a resist pattern have been developed.

As a photoimageable solder resist, a photo-curable and thermosetting liquid coating composition comprising a resin curable with an activated energy ray, which is obtained by the reaction of a saturated or unsaturated polybasic acid anhydride with a reaction product of a novolak type epoxy compound and an unsaturated monocarboxylic acid, a photopolymerization initiator, a diluent and an epoxy compound is disclosed in published Japanese Patent Application KOKAI (Early Publication) No. 61-243869 and corresponding U.S. Patent No. 5,009,982. Though this liquid coating composition possesses satisfactory properties as a solder resist, it defies dilution with water and, therefore, must be diluted with a large amount of organic solvent when it is to be applied by the technique of spray coating or curtain coating. Moreover, an organic solvent is also employed for the cleaning of the jig which has been used for applying the coating composition. The use of organic solvent entails the problems of environmental pollution and fire hazard. Thus, the settlement of such problems is desired.

The water-soluble resins generally include the resins which are obtained by neutralizing with an amine such carboxylic group-containing resins as copolymers of acrylic acid with polymerizable monomers, and polyvinyl alcohol, polyethylene glycol, and carboxymethylcellulose, for example. The compositions which use photosensitive resins based on such water-soluble resins as mentioned above, however, are not readily used as solder resists because they fail to acquire the resistance to soldering temperature and the electrical properties which are necessary for a solder resist. Further, the products of neutralization with an amine entail the problem of environmental pollution because they inevitably liberate the amine into the ambient atmosphere when they are thermally cured. As solder resists requiring highly reliable resistance to soldering temperature and electrical insulation, therefore, the organic solvent type liquid coating compositions mentioned above have been generally used inevitably.

As a water-soluble photoimageable solder resist, the composition which has as essential components thereof a non-proton type onium salt-containing resin derived from an aromatic epoxy resin compound and a photopolymerization initiator is disclosed in published Japanese Patent Application KOKAI No. 2-1858. However, since this composition is soluble in water, a layer of this composition applied to the substrate surface, even when it is predried at a temperature of 100°C or less, entails the problem of poor tack-free touch of finger due to hygroscopicity. The non-proton type onium salt for the impartation of solubility in water attains thorough thermal decomposition in the step of postcure only with difficulty. Thus, the cured coating film consequently obtained retains ionic groups and exhibits inferior electrical insulating property or the like after absorption of moisture. As another type of photoimageable resist, the cation electrodepositing coating material which has as a main component thereof a cationic water-soluble or water-dispersible resin is disclosed in published Japanese Patent Application KOKAI No. 1-279251. Even when this composition is thermally treated, however, it cannot be used as a solder resist because this composition contains no thermosetting component.

An object of this invention, therefore, is to provide a photo-curable and thermosetting coating composition capable of being diluted with water, which produces a solder resist film excelling in various properties required for solder resist such as resistance to soldering temperature, electrical insulating property, resistance to electrolytic corrosion, resistance to chemicals, and tightness of adhesion and which, after being predried, manifests excellence in tack-free touch of finger, developing property, photo-curing property, and shelf life and proves to be ideal in terms of freedom from environmental pollution and fire hazard.

Another object of this invention is to provide a method for the formation of a solder resist pattern by the steps of applying the coating composition to a printed circuit board, selectively exposing the applied layer to an actinic ray, developing the coating film with a dilute aqueous acid solution having only a sparing skin-stimulating property thereby forming a resist pattern unlike the conventional method for the formation of a solder resist pattern by the use of a dilute aqueous alkaline solution, and thereafter thermally curing the formed

resist film.

A further object of this invention is to provide a printed circuit board comprising a solder resist film which is formed thereon in a prescribed pattern and excels in various properties as mentioned above.

To accomplish the objects described above, in accordance with this invention, there is provided a photo-curable and thermosetting coating composition which can be diluted and washed with water, characterized by comprising a tertiary amine compound having at least one ethylenically unsaturated bond in the molecule, a photopolymerization initiator, a diluent, and an epoxy resin, said tertiary amine compound being used as neutralized with a carboxylic acid and said epoxy resin being incorporated therein in the proportion of 2 to 15 equivalents per equivalent of said carboxylic acid to be used for said neutralization.

Further in accordance with this invention, there is provided a method for the formation of a solder resist pattern on a printed circuit board which comprises the steps of applying the aforementioned coating composition to a printed circuit board, predrying the coating of the composition thereby imparting hydrophobicity to the coating film, exposing the coating film to an actinic ray, developing the coating film with a dilute aqueous acid solution having only a sparing skin-stimulating property thereby forming a resist pattern therein, and thereafter heating the patterned film thereby thermosetting the formed resist film. By this method, there is obtained a printed circuit board which comprises a printed circuit board having a circuit formed thereon and a resist film made of a cured product of a tertiary amine compound having at least one ethylenically unsaturated bond in the molecule and an epoxy resin and superposed in a prescribed pattern on said printed circuit board.

As a result of a diligent study in search of coating compositions for solder resists which can be diluted with water, the present inventors have found that a photo-curable and thermosetting coating composition excellent in resistance to soldering temperature and in electrical insulation and capable of being diluted with water and washed with water can be obtained by combining a tertiary amine compound having at least one ethylenically unsaturated bond in the molecule, a photopolymerization initiator, a diluent, and an epoxy resin as a thermosetting component, provided that the tertiary amine compound is used as neutralized with a carboxylic acid and the epoxy resin is incorporated in the proportion of 2 to 15 equivalents per equivalent of the carboxylic acid to be used for the neutralization, and that the photo-curable and thermosetting coating composition is free from the problems of environmental pollution and fire hazard which are inherent in the conventional liquid photoimageable solder resist.

Now, the mechanism for the formation of a solder resist pattern in accordance with this invention will be described below with reference to the drawing attached hereto, which is a graph showing the differential scanning calorimetry (DSC) curve obtained of a coating composition of this invention.

When said photo-curable and thermosetting coating composition of this invention which is capable of being diluted with water is subjected to the heat treatment during the process of predrying, the carboxylic acid which has been used for the neutralization is consumed by a reaction of the following formula (1) and the hydrophobic nature is rendered to the composition.

Mechanism for impartation of hydrophobicity during the step of predrying:

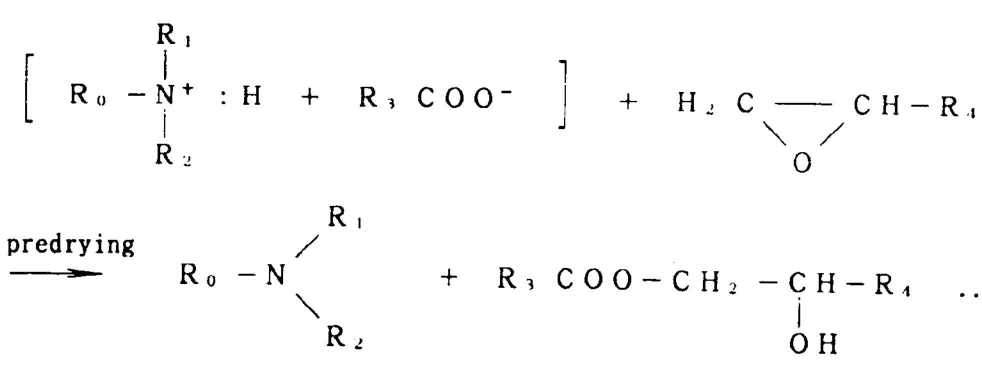


...... (1)

[wherein $R_0$ stands for the residue occurring after removal of one tertiary amine from the tertiary amine compound possessing ethylenically unsaturated bond(s), $R_1$ and $R_2$ independently stand for an alkyl group, alkylene group, or alkanol group having 1 to 6 carbon atoms (wherein $R_1$ and $R_2$ may jointly form a cyclic compound or a heterocyclic compound), $R_3$ stands for H, an alkyl group, halogenated alkyl group, alkylene group, or alkanol group having 1 to 6 carbon atoms, and $R_4$ stands for the residue occurring after removal of one epoxy group from the epoxy resin].

In the step of development with a dilute aqueous acid solution, the portion of the coating which has escaped being photo-crosslinked is rendered soluble in water by the neutralization of the tertiary amine compound in

the composition with the dilute aqueous acid solution as shown by the following formula (2) and consequently removed from the substrate.

Mechanism of re-solution during the step of development:

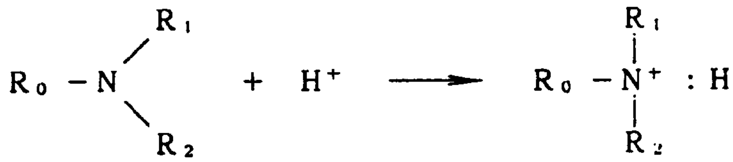

...... (2)

(wherein the symbols have the same meanings as defined above).

The fact that the proton type quaternary ammonium salt produced by the neutralization of the tertiary amine compound possessing ethylenically unsaturated bond(s) in the molecule with the carboxylic acid reacts with the epoxy resin in the step of predrying as represented by the aforementioned reaction formula (1) is verified by the differential scanning calorimetry curve shown in the accompanying drawing. This drawing shows the result obtained by measuring with a differential scanning calorimeter the quantity of heat of reaction generated in the sample, i.e. 5 mg of a comnosition prepared by neutralizing 27 g of B-2 varnish obtained in Synthetic Exampie 3 to be cited hereinbelow with 1.8 g of lactic acid in the ratio of 0.9 equivalent and adding to the product of this neutralization a bisphenol A type epoxy resin (product of Yuka-Shell K.K. marketed under trademark designation of "EPIKOTE 828". epoxy equivalent; 190) in an amount (19g) of 5 equivalents per equivalent of the lactic acid. by heating the sample from normal room temperature to 300°C at a temperature increasing rate of 5 °C/min. The fact that the impartation of hydrophobicity is attained by the reaction occurring between the carboxylic acid and the epoxy resin as represented by the formula (1) mentioned above is evident from the first exothermic peak (110.1°C) appearing in the graph. Then, the fact that by further continuing the heating mentioned above, the epoxy resin is cured with the tertiary amine compound in the composition is verified by the second exothermic peak (146.3°C).

As mentioned above, in the coating composition of this invention, the carboxylic acid used for neutralization is consumed by the epoxy resin and the coating film is consequently vested with hydrophobicity in the step of predrying after application of the composition to the substrate surface. Even when the coating film is left standing after being predried, therefore, it manifests the characteristic feature of avoiding absorption of moisture or loss of tack-free touch of finger. Further, since the epoxy resin is contained in the composition in an excess amount relative to the carboxylic acid used for neutralization, the portion of the epoxy resin which survives the reaction with the carboxylic acid used for neutralization is thermally cured with the tertiary amine compound and an optionally added curing agent for epoxy resin in the subsequent heat treatment and the ionic groups do not remain in the thermally cured composition, which avoids entailing the problem of sacrificing such properties as electrical insulation due to absorption of moisture which is inherently suffered by the conventional water-soluble coating composition. The coating composition of this invention, therefore, is stable in spite of the inherent ability to be diluted with water. Thus, the coating film after being predried excels in such properties as tack-free touch of finger, developing property, photo-curing property, and life. When the coating composition of this invention is applied to a printed circuit board, predried, exposed to an actinic ray, and subjected to development and post-curing, the produced solder resist film manifests a conspicuous improvement in resistance to heat and in electrical insulation, the effect never attainable by the conventional water-diluting composition. Thus, the solder resist film so produced with the composition of this invention excels in such properties as resistance to soldering temperature, electrical insulation, resistance to electrolytic corrosion, resistance to chemicals, and tightness of adhesion which are required for solder resist. Further, the coating composition of this invention is capable of being diluted with water and the jig which has been used for the application of the composition can be cleaned with tap water. Thus, this composition can eliminate such problems of the conventional liquid photoimageable solder resist as pollution of the working environment and exposure of the working environment to fire hazard.

Incidentally, as the developing solution, a dilute aqueous acid solution such as, for example, an aqueous solution containing lactic acid at a concentration in the range of from 0.5 to 3% by weight or an aqueous solution containing glycolic acid at a concentration in the range of from 0.5 to 3% by weight, which possesses only a meager skin-stimulating property and which, when suffered to adhere to the surface of the coating film at the step of development, is enabled to react with the cured film by the heat treatment can be used. These developing solutions may well be called proper in terms of smell and price.

For the synthesis of the tertiary amine compound having ethylenically unsaturated bond(s) in the molecule (hereinafter referred to occasionally as "photosensitive resin"), the following reactions can be used.

(A) The reaction of a secondary amine with a part of the epoxy groups of the epoxy resin and the subsequent reaction of a monocarboxylic acid having an ethylenically unsaturated bond with the remaining epoxy groups.

(B) The Michael reaction of a secondary amine with a part of the ethylenically unsaturated bonds of a compound having at least two ethylenically unsaturated bonds.

(C) The reaction of a monocarboxylic acid having an ethylenically unsaturated bond with a glycidyl amine compound having a tertiary amine.

Besides the reactions enumerated above, the methods which attain introduction of a tertiary amine by use of the Mannich reaction and the reaction of urethanation are likewise available.

As the epoxy resin for the sake of the reaction (A) mentioned above, any types of the conventional epoxy resins well known in the art such as bisphenol A type, hydrogenated bisphenol A type, bisphenol F type, bisphenol S type, phenol novolak type, cresol novolak type, and bisphenol A-based novolak type epoxy resins can be used. Among other epoxy resins so available, the polyfuntional epoxy resins such as phenol novolak type, cresol novolak type, and bisphenol A-based novolak type epoxy resins prove to be particularly desirable in view of photo-curing property and resistance to soldering temperature. The secondary amines which are usable for the partial addition to the epoxy groups include such aliphatic secondary amines as dimethylamine, diethylamine, diallylamine, diisopropylamine, diisobutylamine, diethanolamine, morpholine, and piperidine, for example. These secondary amines may be used either singly or in the form of a combination of two or more members. Among other secondary amines cited above, diethanolamine, morpholine, and piperidine prove to be particularly desirable from the viewpoint of ease of reaction. Examples of the monocarboxylic acid having an ethylenically unsaturated bond, which is intended for the reaction with the residual epoxy group, include acrylic acid, methacrylic acid, cinnamic acid, and the reaction product of a saturated or unsaturated dibasic acid anhydride with a (meth)acrylate having one hydroxyl group per molecule. These compounds may be used either singly or in the form of a combination of two or more members. Among other monocarboxylic acids cited above, acrylic acid and methacrylic acid prove to be particularly desirable from the standpoint of the photo-curing property.

The compounds having at least two ethylenically unsaturated bonds and usable for the sake of the reaction of (B) mentioned above include acrylates such as trimethylolpropane triacrylate, pentaerythritol tetraacrylate, and dipentaerythritol hexaacrylate; such well-known epoxy acrylates of the bisphenol A type, hydrogenated bisphenol A type, bisphenol F type, bisphenol S type, phenol novolak type, cresol novolak type, and bisphenol A-based novolak type; methacrylates or epoxy methacrylates corresponding to the acrylates or epoxy acrylates cited above; and epoxyurethane acrylates resulting from the reaction of an isocyanate group-containing (meth)acrylate [inclusive of the product of half urethanation of a diisocyanate with a hydroxyl group-containing (meth)aclylate] with the epoxy (meth)acrylates mentioned above, for example. Among other compounds mentioned above, epoxy acrylates and epoxyurethane acrylates prove to be particularly desirable from the viewpoint of tack-free touch of finger. The secondary amines which are usable for the Michael reaction to said compound having ethylenically unsaturated bonds include such aliphatic secondary amines as dimethylamine, diethylamine, diallylamine, diisopropylamine, diisobutylamine, diethanolamine, morpholine, and piperidine and such secondary amine-containing imidazoles as the products of Shikoku Chemicals Co., Ltd. marketed under registered trademark designation of "CUREZOL" 2MZ, 2E4MZ and $C_{11}Z$. These secondary amines may be used either singly or in the form of a combination of two or more members. Among other secondary amines mentioned above, diethanolamine, morpholine, piperidine, 2MZ, and 2E4MZ prove to be particularly desirable from the viewpoint of ease of reaction and ease of impartation of water-solubility after neutralization.

The glycidyl amine compounds which are usable for the sake of the reaction of (C) mentioned above include N,N-diglycidyl aniline, N,N,N′,N′-tetraglycidyl diaminodiphenyl methane, N,N,N′,N′-tetraglycidyl-m-xylylene diamine, and N,N,N′,N′-tetraglycidyl-1,3-bisaminomethyl cyclohexane, for example. Among other glycidyl amine compounds mentioned above, N,N,N′,N′-tetraglycidyl-m-xylylene diamine and N,N,N′,N′-tetraglycidyl-1,3-bisaminomethyl cyclohexane prove to be particularly desirable from the viewpoint of ease of impartation of water-solubility after neutralization. Examples of the monocarboxylic acid having an ethylenically unsaturated bond, which is intended for the reaction with said glycidyl amine compound, include acrylic acid, methacrylic acid, cinnamic acid, and the reaction product of a saturated or unsaturated dibasic acid anhydride with a (meth)acrylate having one hydroxyl group per molecule. These compounds may be used either singly or in the form of a combination of two or more members. Among other monocarboxylic acids cited above, acrylic acid and methacrylic acid prove to be particularly desirable from the viewpoint of the photo-curing property.

The tertiary amine compounds having ethylenically unsaturated bond(s) in the molecule and obtained by the reaction of (A) or (B) mentioned above may be used singly or in the form of a combination of two or more members. The compounds which are obtained by the reaction of (C) mentioned above are not easy to use singly because they have low softening points and consequently suffer from inferior tack-free touch of finger. The

photosensitive compounds obtained by the reaction of (A) mentioned above are not easily synthesized and acquire stability only with difficulty. In view of all these factors, the synthesis by the reaction of (B) mentioned above proves to be most suitable from the commercial point of view.

The amine value of the tertiary amine compound having ethylenically unsaturated bond(s) is desired to fall in the range of from 35 to 150 mg KOH/g, preferably from 50 to 100 mg KOH/g. If the amine value is less than 35 mg KOH/g, tertiary amine compound is not enabled by the neutralization with the carboxylic acid to acquire sufficient solubility in water and is effectively put to use only with difficulty. Conversely, if the amine value exceeds 150 mg KOH/g, there may arise the problem that the composition exhibits low photo-curing property and the cured film to be obtained in the subsequent step suffers from impairment of electrical insulating property.

Examples of the photopolymerization initiators include benzoin and alkyl ethers thereof such as benzoin, benzoin methyl ether, benzoin ethyl ether, and benzoin isopropyl ether; acetophenones such as acetophenone, 2,2-dimethoxy-2-phenyl acetophenone, 2,2-diethoxy-2-phenyl acetophenone, 1,1-dichloroacetophenone, 1-hydroxycyclohexyl phenyl ketone, 2-methyl -1-[4-(methylthio)phenyl]-2-morpholino-propane-1-on, 2-benzyl-2-dimethylamino-1-(4-morpholinophenyl)-1-butanone; anthraquinones such as 2-methylanthraquinone, 2-ethylanthraquinone, 2-t-butyl anthraquinone, 1-chloroanthraquinone, and 2-amylanthraquinone; thioxanthones such as 2,4-dimethylthioxanthone, 2,4-diethylthioxanthone, 2-chlorothioxanthone, and 2,4-diisopropylthioxanthone; ketals such as acetophenone dimethyl ketal and benzyl dimethyl ketal; benzophenones such as benzophenone; and xanthones. These well-known conventional photopolymerization initiators may be used either singly or in the form of a combination of two or more members. Optionally such a photopolymerization initiator may be used in combination with one or more well-known conventional photopolymerization accelerators such as of the benzoic acid type and the tertiary amine type. The amount of the photopolymerization initiator to be used suitably falls in the range of from 1 to 30 parts by weight, preferably from 5 to 25 parts by weight, based on 100 parts by weight of the photosensitive resin component mentioned above. If the amount of the photopolymerization initiator to be used is less than the lower limit of the range mentioned above, the composition will suffer from inferior photo-curing property. Conversely, if the amount exceeds the upper limit of the range, the composition will entail the disadvantage of exhibiting inferior quality for solder resist.

As the diluent mentioned above, water and/or an organic solvent may be used.

As the water to be used for the dilution, deionized water which contains no ionic substance proves to be desirable from the standpoint of enabling the composition to enjoy good shelf stability during storage. The amount of the water to be used is desired to be not more than 100 parts by weight, based on 100 parts by weight of the photosensitive resin mentioned above. If the amount of the water to be used exceeds the upper limit mentioned above, though the quality of the composition is not adversely affected, the inevitable decrease in the concentration of the nonvolatile content entails the disadvantage that the efficiency of the application of composition for obtaining a film thickness necessary for solder resist will decrease.

Examples of organic solvents include ketones, cellosolves, carbitols, cellosolve acetates, carbitol acetates, propylene glycol ethers, dipropylene glycol ethers, propylene glycol ether acetates, dipropylene glycol ether acetates, and aromatic hydrocarbons. Among other organic solvents mentioned above, water-soluble organic solvents prove to be particularly desirable. The amount of the organic solvent to be used is desired to be not more than 50 parts by weight, preferably not more than 30 parts by weight, based on 100 parts by weight of the photosensitive resin mentioned above. If the amount of the organic solvent to be used exceeds the upper limit mentioned above, though the quality of the composition is not adversely affected, the problem of environmental pollution and the problem of fire hazard will be entailed.

As the epoxy resin which serves as a thermosetting component as mentioned above, well-known conventional epoxy resins such as bisphenol A type, hydrogenated bisphenol A type, bisphenol F type, bisphenol S type, phenol novolak type, cresol novolak type, bisphenol A-based novolak type, biphenol type, bixylenol type, and N-glycidyl type epoxy resins and glycidyl ethers of polyethylene glycol and polypropylene glycol may be used either singly or in the form of a combination of two or more members. From the viewpoint of the developing property, the epoxy resin to be used is desired to be of the water-soluble or water-dispersion type.

The water-soluble epoxy resins include such nonionic water-soluble resins as diglycidyl ethers of polyethylene glycol and polypropylene glycol, for example. They also include the resins produced by adding to a liquid epoxy resin a nonionic or cationic surface-active agent thereby imparting thereto solubility in water such as, for example, the resin "Aqua Tohto 510" (trademark of Tohto Resin Kako K.K.) obtained by adding a surface-active agent to a bisphenol A type epoxy resin.

The water-dispersion type epoxy resins include the resins produced by melting solid epoxy resins or dissolving them in a solvent and adding to the resultant liquid a nonionic or cationic surface-active agent such as, for example, the resin "Aqua Tohto 5003" (trademark of Tohto Resin Kako K.K.) obtained by adding a surface-active agent to a novolak type epoxy resin, resins obtained by imparting a self-emulsifying function to

solid cresol novolak type epoxy resins such as, for example, a commercial product of Nagase Kasei K.K. marketed under trademark designation of "DENACOL EM-125", and powdery epoxy resins sparingly soluble in the diluent mentioned above and dispersible in water, such as biphenol type, bixylenol type and bisphenol S type epoxy resins, diglycidyl esters of terephthalic acid, and triglycidyl isocyanurate, for example. Among other water-dispersion type epoxy resins mentioned above, those powdery epoxy resins which are sparingly soluble in said diluent prove to be particularly desirable from the viewpoint of the tack-free touch of finger which the coating film exhibits in the predried state. The term "sparingly soluble resin" as used herein is to be construed as including resins which are partially soluble in the diluent.

The amount of the epoxy resin component to be incorporated in the composition is desired to be in the proportion of 2 to 15 equivalents, preferably 4 to 10 equivalents, per equivalent of the carboxylic acid which has been used for the neutralization of the photosensitive resin component. The epoxy resin, in the step of predrying, manifests the effect of imparting hydrophobicity to the coating film by reacting with the carboxylic acid used for the neutralization. The epoxy group is consumed by the carboxylic acid which has been used for the neutralization as described above. If the proportion of the epoxy resin component is less than two equivalents per equivalent of the carboxylic acid, therefore, there will ensue the disadvantage that the addition of the carboxylic acid to the epoxy resin molecule is induced as attended by monoepoxidation or epoxyesterification, the three-dimensional crosslinking reaction is prevented from proceeding readily during the thermosetting reaction, and the cured film is precluded from acquiring necessary quality sufficiently. Conversely, if the proportion exceeds 15 equivalents per equivalent of the carboxylic acid, the disadvantage will arise that the concentration of the photosensitive group in the composition is lowered to the extent of degrading the photocuring property and the resistance to attack by developing solution. The part of the epoxy group which survives the reaction of the epoxy resin component with the carboxylic acid used for the neutralization is thermally cured with the tertiary amine compound having ethylenically unsaturated bond(s) in the molecule or an optionally added latent curing agent for epoxy resin such as, for example, an imidazole, dicyandiamide, or boron trifluoride monoethylamine complex.

The carboxylic acids which are effectively usable herein for the purpose of neutralizing the tertiary amine compound possessing ethylenically unsaturated bond(s) in the molecule include monocarboxylic acids such as formic acid, acetic acid, propionic acid, acrylic acid, glycolic acid, and lactic acid and dicarboxylic acids such as L-glutamic acid, for example. Among other carboxylic acids mentioned above, monocarboxylic acids prove to be particularly desirable in terms of liquid stability of the product of neutralization, ease of impartation of solubility in water, and developing property after the predrying. From the standpoint of smell, such hydroxycarboxylic acids as lactic acid and glycolic acid which have high boiling points and low levels of volatility prove to be particularly desirable. Unlike other acids, these carboxylic acids are enabled by a heat treatment to react efficiently with the epoxy resin mentioned above to the extent of being deprived of ionicity and giving rise to electrical insulation required for solder resist. The amount of the carboxylic acid to be added is desired to be in the proportion of 0.8 to 2.0 equivalents, preferably 1.0 to 1.4 equivalents, per equivalent of the amine contained in the tertiary amine compound possessing ethylenically unsaturated bond(s) in the molecule. If the amount of the carboxylic acid to be added is less than the lower limit of the range mentioned above, there will ensue the disadvantage that the concentration of the hydrophilic quaternary ammonium salt to be formed by the neutralization is too low to allow impartation of solubility in water. Conversely, if the proportion of the carboxylic acid to be added exceeds 2.0 equivalents per equivalent of the amine, since the amount of the epoxy resin to be consumed at the step of heat treatment increases, there will ensue the disadvantage that the amount of the epoxy resin component required to be added for the maintenance of the characteristic quality of the composition is increased and consequently the concentration of the photo-sensitive group in the composition is lowered. The neutralization of the tertiary amine compound with the carboxylic acid mentioned above may be accomplished by either having the tertiary amine compound preparatorily neutralized with the carboxylic acid and adding the resultant product of neutralization to the photo-sensitive resin composition or adding the carboxylic acid to the photosensitive resin composition containing the tertiary amine compound, the photopolymerization initiator, and the diluent during the preparation of this photosensitive resin composition.

The photo-curable and thermosetting coating composition of this invention which is obtained as described above and can be diluted with water may optionally incorporate therein additionally a photopolymerizable monomer. The photopolymerizable monomers which are usable herein include hydroxyl group-containing acrylates such as 2-hydroxyethyl acrylate, 2-hydroxybutyl acrylate, pentaerythritol triacrylate, and dipentaerythritol pentacrylate; acrylamide derivatives such as acrylamide and N-methylolacrylamide; water-soluble acrylates such as polyethylene glycol diacrylate and polypropylene glycol diacrylate; acrylates such as trimethylolpropane triacrylate and pentaerythritol tetraacrylate; and methacrylates corresponding to the acrylates mentioned above, for example. These photopolymerizable monomers may be used either singly or in the form of a combination of two or more members in an amount incapable of causing the problem of dry tack. Among

other photopolymerizable monomers mentioned above, the hydrophilic group-containing (meth)acrylates prove to be particularly desirable in terms of liquid stability of the composition and the polyfunctional (meth)acrylates prove to be particularly desirable in terms of the photo-curing property. Further, such macromolecular compounds as polyvinyl alcohol, polyacrylamide, carboxymethyl cellulose, polyvinyl formal resin, and polyvinyl acetal resin which are water-soluble resins can be used as a protective colloid. The use of the protective colloid is effective in improving the liquid stability of the composition. Likewise for the purpose of improving the liquid stability of the composition, a surface-active agent may be used. From the viewpoints of electrical insulation, resistance to electrolytic corrosion, and liquid stability, the surface-active agent is desired to be of a nonionic type having an HLB (hydrophilic-lipophilic balance) value of not less than 13.

Optionally, such well known and widely used inorganic fillers as barium sulfate, talc, and silica can be used for the purpose of enhancing the characteristic properties of the composition of this invention such as adhesion, hardness, and resistance to soldering temperature. The amount of the inorganic filler to be used is desired to be in the range of not more than 100 parts by weight, preferably 5 to 50 parts by weight, based on 100 parts by weight of the photosensitive resin component mentioned above. Further, well known and widely used additives such as color pigments, thermopolymerization inhibitors, thickening agents, anti-foaming agents, leveling agents, and coupling agents may be used, as occasion demands.

The coating composition of this invention may further incorporate therein, when necessary, other thermosetting resins such as melamine resin, blocked isocyanate, or oxazoline resin in an amount incapable of impairing the developing property thereof.

For the purpose of protecting the circuit of copper formed on the printed circuit board against oxidation, the composition allows use of such a compound as adenine, vinyl triazine, dicyandiamide, orthotolyl biguanide, or melamine, for example. The amount of this compound to be used is desired to be not more than 20 parts by weight, based on 100 parts by weight of the photosensitive resin mentioned above. The addition of this compound is effective in enhancing the resistance of the composition to chemicals.

The liquid coating composition which is prepared as described above and which is consequently enabled to be diluted with water and washed with water is adjusted, when necessary by dilution with water, to a level of viscosity fit for the coating method, applied by the technique of screen printing, curtain coating, spray coating, or roll coating to a printed circuit board having a circuit already formed thereon, and then predried at a temperature in the range of from 60 to 100°C, for example, thereby to impart hydrophobicity to the coating and evaporate the organic solvent and water from the coating and give rise to a tack-free coating film. Then, the composition coated on the printed circuit board is selectively exposed to an actinic ray through a photomask having a prescribed pattern and the composition in the unexposed parts of the coating film is developed with a dilute aqueous acid solution to obtain a resist pattern. The acid which has been consumed at the step of said predrying is replenished with the dilute aqueous acid solution which is used as the developing solution in the process of development. As a result, the coating film can be endowed with hydrophilicity and the unexposed parts which have not undergone photo-crosslinking can be removed. As the dilute aqueous acid solution (developing solution) to be used for the impartation of hydrophilicity to the coating film, inorganic acids such as hydrochloric acid and nitric acid; carboxylic acids such as acetic acid, formic acid, propionic acid, lactic acid, and glycolic acid; sulfonic acids such as p-toluene sulfonic acid; and acidic phosphoric esters can be used. Among other acid sources mentioned above, carboxylic acids prove to be particularly desirable in respect that even when they adhere to the surface of a photo-cured coating film, they are deprived of ionicity owing to their reaction with the epoxy group. From the standpoint of the smell, lactic acid and glycolic acid which are hydroxycarboxylic acids having high boiling points prove to be particularly desirable. The concentration of the acid in the dilute aqueous acid solution is desired to be in the range of from 0.5 to 3% by weight in terms of the solubility of the composition in unexposed areas and the resistance of the photo-cured coating film to the attack by developing solution.

Thereafter, the photo-cured coating film is further thermally cured by subjecting to the heat treatment at a temperature in the range of from 140 to 180°C, for example, to form a solder resist film which excels in adhesion, hardness, resistance to soldering temperature, resistance to chemicals, resistance to solvents, electrical insulation, and resistance to electrolytic corrosion.

The light sources which are advantageously used for the purpose of photo-curing of the composition include low-pressure mercury lamp, medium-pressure mercury lamp, high-pressure mercury lamp, ultra-high-pressure mercury lamp, xenon lamp, and metal halide lamp, for example. The laser beam can be utilized as the actinic ray for exposure of the film. Besides them, electron beam, $\alpha$ ray, $\beta$ ray, $\gamma$ ray, X ray, and neutron ray are likewise usable.

Now, this invention will be described more specifically below with reference to working examples of this invention and comparative experiments. Wherever parts and percents are mentioned hereinbelow, they invariably refer to those based on weight unless otherwise specified.

Synthetic Example 1:

Into a four-necked flask equipped with a stirrer and a reflux condenser, 220 parts of a cresol novolak type epoxy resin (product of Dai-Nippon Ink & Chemicals, Inc. marketed under trademark designation of "EPICLON N-695", epoxy equivalent; 220) was introduced, 168 parts of dipropylene glycol monomethyl ether was added thereto, and the mixture was dissolved by heating. The resultant resinous solution and 35 parts of diethanolamine added gradually and dropwise thereto were left reacting at 60 to 70°C for three hours. To the reaction product, 0.05 part of hydroquinone was added as a polymerization inhibitor. The resultant mixture heated to 85 to 95°C and 48 parts of acrylic acid gradually added dropwise thereto were left reacting for five hours, to obtain a photosensitive resinous solution having a nonvolatile content of 64% and an amine value of the solid content of 62 mg KOH/g (hereinafter referred to as "A-1 varnish").

Synthetic Example 2:

Into a four-necked flask equipped with a stirrer and a reflux condenser, 220 parts of a cresol novolak type epoxy resin (EPICLON N-695) was introduced, 168 parts of dipropylene glycol monomethyl ether was added thereto, and the mixture was dissolved by heating. To this resinous solution, 0.05 part of hydroquinone as a polymerization inhibitor and 1.0 part of dimethylbenzylamine as a reaction catalyst were added. The resultant mixture heated to 85 to 95°C and 72 parts of acrylic acid gradually added dropwise thereto were left reacting for 12 hours, to obtain an epoxy acrylate solution. The epoxy acrylate solution heated to 65 to 75°C and 35 g of diethanolamine gradually added dropwise thereto were left undergoing a Michael reaction for three hours.

The photosensitive resinous solution consequently obtained (hereinafter referred to as "B-1 varnish") was found to have a nonvolatile content of 66% and an amine value (as reduced to solid content) of 57 mg KOH/g.

Synthetic Example 3:

Into a four-necked flask equipped with a stirrer and a reflux condenser, 220 parts of a cresol novolak type epoxy resin (product of Dai-Nippon Ink & Chemicals, Inc. marketed under trademark designation of "EPICLON N-680", epoxy equivalent; 220) was introduced, 168 parts of carbitol acetate was added thereto, and the mixture was dissolved by heating. To this resinous solution, 0.05 part of hydroquinone as a polymerization inhibitor and 1.0 part of dimethylbenzylamine as a reaction catalyst were added. The resultant mixture heated to 85 to 95°C and 72 parts of acrylic acid gradually added dropwise thereto were left reacting for 12 hours. The epoxy acrylate produced consequently and 128.4 parts of a half urethane prepared in advance by equimolar reaction of isophorone diisocyanate with 2-hydroxyethyl acrylate gradually added dropwise thereto were left reacting at 60 to 70°C for two hours.

The reaction product and 35 parts of diethanolamine and 5.5 parts of 2E4MZ (a secondary amine-containing imidazole derivative produced by Shikoku Kasei K.K.) gradually added dropwise thereto were left undergoing a Michael reaction at 65 to 75°C for four hours.

The photosensitive resinous solution thus obtained (hereinafter referred to as "B-2 varnish") was found to have a nonvolatile content of 67% and an amine value of the solid content of 48 mg KOH/g.

Synthetic Example 4:

In a four-necked flask equipped with a stirrer and a reflux condenser, 578 parts of a photopolymerizable polyfunctional monomer (product of Nippon Kayaku Co., Ltd. marketed under product code of "DPHA") was heated to 55 to 65°C, 87 parts of morpholine was gradually added dropwise thereto, and they were left undergoing a Michael reaction for four hours.

The reaction product thus obtained (hereinafter referred to as "B-3 compound") was found to have an amine value of 84 mg KOH/g.

Example 1:

The following components including A-1 varnish obtained in Synthetic Example 1 and neutralized in equivalent ratio with lactic acid, and dicyandiamide and imidazole (product of Shikoku Kasei K.K. marketed under product code of "2PHZ") as latent curing agents for epoxy resin were kneaded with a three-roll mill to prepare a water-soluble photosensitive resin composition (hereinafter referred to as "R-1").

| | |
|---|---|
| A-1 varnish | 50 parts |
| Lactic acid | 3.3 parts |
| Photopolymerization initiator (product of Chiba-Geigy marketed under trademark designation of "IRGACURE 651") | 4 parts |
| Dipentaerythritol hexaacrylate | 3 parts |
| N,N'-methylene-bis-acrylamide | 1 part |
| 2PHZ | 0.8 part |
| Dicyandiamide | 0.2 part |
| Barium sulfate | 30 parts |
| Phthalocyanine green | 0.7 part |
| Dimethyl polysiloxane (silicone type anti-foaming agent) | 1 part |
| Finely divided silica | 2 parts |
| Deionized water | 4 parts |
| Total: | 100 parts |

As a cross-linking agent for the composition mentioned above, the following epoxy resin components were kneaded with a three-roll mill to prepare a water-soluble epoxy resin composition (hereinafter referred to as "H-1").

| | |
|---|---|
| Bisphenol A type epoxy resin (product of Tohto Resin Kako K.K. marketed under trademark designation of "Aqua Tohto 510") | 20 parts |
| Triglycidyl isocyanurate | 60 parts |
| Carbitol acetate | 10 parts |
| Deionized water | 10 parts |
| Total: | 100 parts |

R-1 and H-1 prepared as described above were mixed in the following ratio to obtain a photo-curable and thermosetting coating composition capable of being diluted with water.

R-1 : H-1 = 70 : 30

(Number of equivalents of epoxide/number of equivalents of carboxylic acid = 7.8)

Examples 2 and 3 and Comparative Experiment 1:

The following components including B-1 varnish obtained in Synthetic Example 2 were kneaded with a three-roll mill to prepare a photosensitive resin composition (hereinafter referred to as "R-2 base").

| | |
|---|---|
| B-1 varnish | 50 parts |
| IRGACURE 651 | 4 parts |
| Pentaerythritol triacrylate | 3 parts |
| N,N'-methylene-bis-acrylamide | 3 parts |
| 2PHZ | 1.5 parts |
| Phthalocyanine green | 0.5 part |
| Dimethyl polysiloxane (silicone type anti-foaming agent) | 1 part |
| Silica | 30 parts |
| Total: | 93 parts |

By adding to the photosensitive resin composition, R-2 base, obtained as described above lactic acid in the proportion of 1.2 equivalent per equivalent of the amine contained in said resin composition, a water-soluble photosensitive resin composition comprising the following components (hereinafter referred to as "R-2") was prepared.

| | |
|---|---|
| R-2 base | 93 parts |
| Lactic acid | 3.6 parts |
| Deionized water | 3.4 parts |
| Total: | 100 parts |

As a cross-linking agent for the water-soluble photosensitive resin, the following components including a water-dispersion type epoxy resin (product of Tohto Resin Kako K.K. marketed under trademark designation of "Aqua Tohto 5003", nonvolatile content; 55%, epoxy equivalent of solid content; 205) and a powdery epoxy resin were stirred and dispersed with a homogenizer, to prepare a water-dispersion type epoxy resin composition (hereinafter referred to as "H-2").

| | |
|---|---|
| Aqua Tohto 5003 | 50 parts |
| Triglycidyl isocyanurate | 40 parts |
| Polyvinyl acetal resin (product of Sekisui Chemical Co., Ltd. marketed under product code of "S-LEC KW-1") | 8 parts |
| Finely divided silica | 2 parts |
| Total: | 100 parts |

R-2 and H-2 prepared as described above were mixed at the following ratio, to obtain a photo-curable and thermosetting coating composition capable of being diluted with water.

Example 2 R-2 : H-2 = 80 : 20

(Number of equivalents of epoxide/number of equivalents of carboxylic acid = 3.2)

Example 3 R-2 : H-2 = 70 : 30

(Number of equivalents of epoxide/number of equivalents of carboxylic acid = 5.5)

Comparative Experiment 1 R-2 : H-2 = 90 : 10

(Number of equivalents of epoxide/number of equivalents of carboxylic acid = 1.4)

Example 4:

The following components including B-2 varnish and B-3 compound obtained in Synthetic Examples 3 and 4 were kneaded with a three-roll mill to prepare a water-soluble photosensitive resin composition (hereinafter referred to as "R-3").

| | |
|---|---|
| B-2 varnish | 60 parts |
| B-3 compound | 6 parts |
| IRGACURE 651 | 5 parts |
| Phthalocyanine green | 1 part |
| Dimethyl polysiloxane (silicone type anti-foaming agent) | 1 part |
| Talc | 20 parts |
| Finely divided silica | 1 part |
| Lactic acid | 4 parts |
| Deionized water | 2 parts |
| Total: | 100 parts |

As a cross-linking agent for the composition mentioned above, the following components including epoxy resins and water-soluble resin were kneaded with a three-roll mill to prepare a water-soluble epoxy resin composition (hereinafter referred to as "H-3").

| | |
|---|---|
| Aqua Tohto 510 | 10 parts |
| Melamine resin (product of Sanwa Chemicals Co., Ltd. marketed under product code of "NIKALAC MW-30") | 4 parts |
| Water-dispersion type cresol novolak epoxy resin (product of Nagase Kasei K.K. marketed under trademark designation of "DENACOL EM-125") | 20 parts |
| Bixylenol diglycidyl ether | 40 parts |
| Triglycidyl isocyanurate | 10 parts |
| Finely divided silica | 6 parts |
| Carbitol acetate | 10 parts |
| Total | 100 parts |

R-3 and H-3 prepared as described above were mixed in the following ratio, to obtain a photo-curable and thermosetting coating composition capable of being diluted with water.

R-3 : H-3 = 60 : 40

(Number of equivalents of epoxide/number of equivalents of carboxylic acid = 5.8)

[Evaluation of quality]

(1) Test for heat fogging

Each of the compositions obtained in the working examples and the comparative experiment cited above was applied by a screen printing method onto the entire surface of copper-clad substrate having a prescribed pattern formed in advance thereon and then predried at 80°C for periods graduated at an interval of 5 minutes. The coating films consequently formed on the substrates were exposed to an actinic ray according to a solder resist pattern through a negative film tightly superposed thereon. They were then developed with an aqueous 1 wt% lactic acid solution to test for life (the longest predrying period allowing effective development).

Separately, each of the compositions obtained in the working examples and the comparative experiment cited above was applied by the screen printing method onto the entire surface of copper-clad substrate having a prescribed pattern formed in advance thereon and then predried at 80°C for 30 minutes. The coating films on the substrates were exposed to an actinic ray according to a solder resist pattern through a negative film tightly superposed thereon and then developed with an aqueous 1 wt% lactic acid solution to form a resist pattern thereon. The coating films on the substrates were thermally cured at 150°C for 30 minutes to prepare sample substrates, which were used for evaluation of the following properties.

(2) Resistance to soldering temperature

This property was determined by coating a sample substrate with a rosin-based flux, immersing the coated sample substrate for 30 seconds in a solder bath set in advance at 260°C, rinsing the sample with trichloroethane thereby removing the flux therefrom, and visually examining the sample to find the extents of swelling, separation, and discoloration consequently produced in the resist layer on the sample substrate. These phenomena were rated on the following three-point scale.

○ : Perfect absence of any discernible change

△ : Slight change of the resist layer

X : Presence of discernible swelling, separation, and discoloration of the resist layer

(3) Resistance to acids

This property was determined by immersing for 30 minutes said sample substrate in an aqueous solution containing 10% by volume of sulfuric acid at normal room temperature, washing the wetted sample substrate with water, and subjecting the cleaned sample substrate to a peel test using an adhesive tape to find the extents of separation and discoloration consequently produced in the resist layer. These phenomena were rated on the following three-point scale.

○ : Perfect absence of any discernible change

△ : Slight change of the resist layer

X : Presence of discernible separation and discoloration of the resist layer

(4) Insulation resistance

This property was determined by preparing a sample substrate under the conditions mentioned above using a comb type electrode B coupon of IPC B-25, applying a bias voltage of DC 500 V to the comb type electrode, and measuring the initial insulation resistance. This sample substrate was left standing for 200 hours in a thermo-hygrostat kept at 40°C and 95% R.H. After humidification, the sample substrate was tested for insulation resistance in the same manner as described above.

Further, the compositions obtained in the working examples and the comparative experiment cited above were evaluated for storage stability as follows.

(5) Storage stability

A given composition was left standing in a constant-temperature bath at 20°C for one month and then visually examined to find the extents of change in property and in viscosity and evaluate stability during storage. The stability was rated on the following three-point scale.

○ : Absence of layer separation and a change of viscosity not more than twice the initial value

△ : Absence of layer separation and a change of viscosity at least twice the initial value

X : Presence of layer separation or occurrence of gelation

(6) Ability to be diluted with water

This property was determined by diluting a given composition with deionized water to 0.2 Pa.s (2 poises) stirring and mixing the diluted composition, allowing the composition to stand at rest at normal room temperature for one day, and visually examining the diluted composition to find the extents of change in property and in viscosity, thereby evaluating the ability of the composition to be diluted with water. The property was rated on the following three-point scale.

○ : Absence of phase separation and absence of any noticeable change in viscosity

△ : Absence of phase separation and occurrence of waxy state

X : Presence of phase separation or occurrence of gelation

(7) Characteristic properties of composition diluted with water

For determination of this property, a sample substrate was obtained by diluting a given composition to 0.2 Pa·s (2 poises) as described above, applying the diluted composition by the spray coating method to a copper-clad substrate having a prescribed pattern formed in advance thereon, predrying the coating on the substrate at 80°C for 30 minutes thereby obtaining a tack-free coating film. The coating film on the substrate was exposed to UV rays according to a solder resist pattern through a negative film superposed tightly thereon, developed with an aqueous 1 wt% lactic acid solution thereby forming a resist pattern, and then thermally cured at 150°C for 30 minutes to prepare a sample substrate.

The sample substrate was evaluated for resistance to soldering temperature, resistance to acids, and insulation resistance as described above. Then, the sample substrate used for this evaluation was compared with the sample substrate prepared by the screen printing to determine the presence or absence of a degradation of characteristic properties.

The results of these evaluations are shown in the Table.

Table

| Item of evaluation | | Example 1 | Example 2 | Example 3 | Example 4 | Comparative Experiment 1 |
|---|---|---|---|---|---|---|
| (1) Heat fogging (80 °C) | Aqueous 1 wt% lactic acid solution Spray pressure 2 $kg/cm^2$ Developing time= 1 min. | 100 minutes | 90 minutes | 120 minutes | 120 minutes | 60 minutes |
| (2) Resistance to soldering temperature (260°C, 30 seconds) | | ○ | △ | ○ | ○ | △ |
| (3) Resistance to acid (10% $H_2SO_4$) | 30 minutes' immersion | ○ | △ | ○ | ○ | × |
| (4) Insulation resistance (Ω) | (Initial value) | At least $10^{13}$ | At least $10^{12}$ | At least $10^{13}$ | At least $10^{13}$ | At least $10^{12}$ |
| | (After humidification) | At least $10^{11}$ | At least $10^{10}$ | At least $10^{11}$ | At least $10^{11}$ | At least $10^{8}$ |
| (5) Storage stability of composition | | ○ | ○ | ○ | △ | ○ |
| (6) Ability to be diluted with water (dilution up to 2 Ps.) | | ○ | ○ | ○ | ○ | △ |
| (7) Degradation of properties of composition diluted with water | | No | No | No | No | Yes |

## Claims

1. A liquid photo-curable and thermosetting coating composition which can be diluted and washed with water comprising a tertiary amine compound having at least one ethylenically unsaturated bond in the molecule and being used as neutralized with a carboxylic acid, a photopolymerization initiator, a diluent, and an epoxy resin, characterized in that said epoxy resin is incorporated therein in the proportion of 2 to 15 equivalents per equivalent of said carboxylic acid to be used for said neutralization.

2. A composition according to claim 1, which comprises a photosensitive resin composition containing a tertiary amine compound having at least one ethylenically unsaturated bond in the molecule, a photopolymerization initiator, and a diluent, said tertiary amine compound being neutralized with a carboxylic acid, and a thermosetting resin composition containing an epoxy resin in the proportion of 2 to 15 equivalents per equivalent of said carboxylic acid used for said neutralization of the tertiary amine compound.

3. A composition according to claim 1 or 2, wherein said tertiary amine compound has an amine value in the range of from 35 to 150 mg KOH/g.

4. A composition according to any one of claims 1 to 3, wherein said tertiary amine compound is a compound which is obtained by adding a secondary amine to a part of ethylenically unsaturated bonds of a compound having at least two ethylenically unsaturated bonds.

5. A composition according to claim 4, wherein said secondary amine is a compound selected from the group consisting of aliphatic secondary amines and secondary amine-containing imidazoles, and said compound having at least two ethylenically unsaturated bonds is a compound selected from the group consisting of polyfunctional (meth)acrylates, epoxy (meth)acrylates, and epoxyurethane (meth)acrylates.

6. A composition according to any one of claims 1 to 5, wherein said carboxylic acid is a monocarboxylic acid which is hydrophilic and capable of reacting with said epoxy resin component.

7. A composition according to any one of claims 1 to 6, wherein said carboxylic acid is used in the proportion of 0.8 to 2.0 equivalents per equivalent of amine contained in said tertiary amine compound.

8. A composition according to any one of claims 1 to 7, wherein said epoxy resin is at least one member selected from the group consisting of water-soluble epoxy resins and water-dispersion type epoxy resin.

9. A composition according to any one of claims 1 to 8, wherein said photopolymerization initiator is at least one compound selected from benzoin and alkyl ethers thereof, acetophenones, anthraquinones, ketals, benzophenones, and xanthones and is used in the proportion in the range of from 1 to 30 parts by weight, based on 100 parts by weight of said tertiary amine compound.

10. A composition according to any one of claims 1 to 9, wherein said diluent is water and/or an organic solvent.

11. A composition according to any one of claims 1 to 10, which further contains at least one additive selected from the group consisting of photopolymerizable monomers, macromolecular compounds, surface-active agents, inorganic fillers, color pigments, thermopolymerization inhibitors, thickening agents, anti-foaming agents, leveling agents, coupling agents, and anti-oxidizing agents.

12. A method for the formation of a solder resist pattern, characterized by applying a liquid photo-curable and thermosetting coating composition set forth in any one of claims 1 to 11 to a printed circuit board, then predrying the coating of the composition thereby imparting hydrophobicity to the coating film, selectively exposing the coating film to an actinic ray, developing the coating film with a dilute aqueous acid solution thereby forming a resist pattern therein, and thereafter heating the patterned film thereby thermosetting the formed resist film.

13. A method according to claim 12, wherein said application of the composition to a printed circuit board is effected by a screen printing method, a curtain coating method, a spray coating method, or a roll coating method.

14. A method according to claim 12 or 13, wherein said dilute aqueous acid solution is an aqueous solution containing an inorganic acid, a carboxylic acid, a sulfonic acid, or an acidic phosphoric ester at a concentration in the range of from 0.5 to 3% by weight.

15. A method according to any one of claims 12 to 14, wherein said predrying is effected at a temperature in the range of from 60 to 100°C and said heating of the patterned film after development is carried out at a temperature in the range of from 140 to 180°C.

16. A printed circuit board arrangement, comprising a printed circuit board arrangement having a circuit formed thereon and a resist film made of a cured product produced from a composition according to claim 1 and superposed in a prescribed pattern on said printed circuit board.

## Patentansprüche

1. Flüssige foto- und wärmehärtende Beschichtungszusammensetzung, die mit Wasser verdünnt und gewaschen werden kann, umfassend eine tertiäre Aminverbindung mit zumindest einer ethylenisch ungesättigten Bindung im Molekül, die, neutralisiert mit einer Carbonsäure, verwendet wird, einen Fotopolymerisationsinitiator, ein Verdünnungsmittel und ein Epoxyharz, dadurch gekennzeichnet, daß das Epoxyharz in dem Anteil von 2-15 Äquivalenten pro Äquivalent der zur Neutralisation zu benutzenden Carbonsäure darin eingearbeitet ist.

2. Zusammensetzung gemäß Anspruch 1, umfassend eine lichtempfindliche Harzzusammensetzung mit einem Gehalt an einer tertiären Aminverbindung, die zumindest eine ethylenisch ungesättigt Bindung im Molekül besitzt, einen Fotopolymerisationsinitiator und ein Verdünnungsmittel, wobei die tertiäre Aminverbindung mit einer Carbonsäure neutralisiert ist, sowie eine wärmehärtbare Harzzusammensetzung mit einem Gehalt an einem Epoxyharz im Anteil von 2-15 Äquivalenten pro Äquivalent dieser für die Neutralisation der tertiären Aminverbindung benutzten Carbonsäure.

3. Zusammensetzung gemäß Anspruch 1 oder 2, bei der die tertiäre Aminverbindung einen Aminwert im Bereich von 35-150 mg KOH/g hat.

4. Zusammensetzung gemäß einem der Ansprüche 1-3, bei der die tertiäre Aminverbindung eine Verbindung ist, welche durch Zugabe eines sekundären Amins zu einem Teil der ethylenisch ungesättigten Bindungen einer Verbindung erhalten wurde, die wenigstens zwei ethylenisch ungesättigte Bindungen aufweist.

5. Zusammensetzung gemäß Anspruch 4, bei der das sekundäre Amin eine Verbindung ist, ausgewählt aus der Gruppe, die besteht aus aliphatischen sekundären Aminen und sekundäre Amine enthaltenden Imidazolen, und die Verbindung mit zumindest zwei ethylenisch ungesättigten Bindungen eine Verbindung ist, ausgewählt aus der Gruppe, die aus polyfunktionellen (Meth)acrylaten, Epoxy(meth)acrylaten und Epoxyurethan(meth)acrylaten besteht.

6. Zusammensetzungen gemäß einem der Ansprüche 1-5, bei der die Carbonsäure eine Monocarbonsäure ist, die hydrophil und einer Reaktion mit der Epoxyharzkomponente fähig ist.

7. Zusammensetzung gemäß einem der Ansprüche 1-6, bei der die Carbonsäure in dem Anteil von 0,8-2,0 Äquivalenten pro Äquivalent des in der tertiären Aminverbindung enthaltenen Amins verwendet wird.

8. Zusammensetzung gemäß einem der Ansprüche 1-7, bei der das Epoxyharz zumindest ein Glied, ausgewählt aus der Gruppe, die aus wasserlöslichen Epoxyharzen und Epoxyharzen vom Wasserdispersionstyp besteht, ist.

9. Zusammensetzung gemäß einem der Ansprüche 1-8, bei der der Fotopolymerisationsinitiator zumindest eine Verbindung ist, die aus Benzoin und dessen Alkyläthern, Acetophenonen, Anthrachinonen, Ketalen, Benzophenonen und Xanthonen ausgewählt wurde, und die in einem Anteil im Bereich von 1-30 Gewichtsteilen, bezogen auf 100 Gewichtsteile der tertiären Aminverbindung, verwendet ist.

10. Zusammensetzung gemäß einem der Ansprüche 1-9, bei der das Verdünnungsmittel Wasser und/oder

ein organisches Lösungsmittel ist.

**11.** Zusammensetzung gemäß einem der Ansprüche 1-10, ferner enthaltend zumindest ein Additiv, ausgewählt aus der Gruppe, die aus fotopolymerisierbaren Monomeren, makromolekularen Verbindungen, oberflächenaktiven Mitteln, anorganischen Füllstoffen, Farbpigmenten, Thermopolymerisationsinhibitoren, Verdickungsmitteln, Antischäumungsmitteln, Verlaufmitteln, Kupplungsmitteln und Antioxidationsmitteln besteht, ist.

**12.** Zwischen Verfahren zur Bildung einer Resist-Lötmaske, dadurch gekennzeichnet, daß man eine foto- und wärmehärtende Beschichtungszusammensetzung gemäß einem der Ansprüche 1-11 auf eine Leiterplatte aufbringt, die Beschichtung aus der Zusammensetzung sodann vortrocknet, wodurch dem Beschichtungsfilm Hydrophobizität verliehen wird, den Beschichtungsfilm selektiv einer aktinischen Strahlung aussetzt, den Beschichtungsfilm mit einer verdünnten wässerigen Säurelösung entwickelt, wodurch in diesem ein Schutzlackmuster gebildet wird, und sodann den gemusterten Film erwärmt, wodurch der gebildete Schutzlackfilm thermisch gehärtet wird.

**13.** Verfahren gemäß Anspruch 12, bei dem das Aufbringen der Zusammensetzung auf eine Leiterplatte durch ein Siebdruckverfahren, ein Vorhangsbeschichtungsverfahren, ein Sprühbeschichtungs- oder Walzenbeschichtungsverfahren bewirkt wird.

**14.** Verfahren gemäß Anspruch 12 oder 13, bei dem die verdünnte wässerige Lösung eine wässerige Lösung mit einem Gehalt an einer anorganischen Säure, Carbonsäure, Schwefelsäure oder einem sauren Phosphorsäureester in einer Konzentration im Bereich von 0,5-3 Gew.% ist.

**15.** Verfahren gemäß einem der Ansprüche 12-14, bei dem das Vortrocknen bei einer Temperatur im Bereich von 60-100 °C bewirkt wird, und das Erwärmen des gemusterten Films nach der Entwicklung bei einer Temperatur im Bereich von 140-180 °C durchgeführt wird.

**16.** Leiterplattenanordnung, umfassend eine Leiterplattenanordnung mit einer darauf gebildeten Schaltung und einen Schutzlackfilm aus einem gehärteten Produkt, das aus einer Zusammensetzung gemäβ Anspruch 1 hergestellt wurde und in einem vorgeschriebenen Muster auf der Leiterplatte angeordnet ist.

## Revendications

**1.** Composition de revêtement liquide thermodurcissable et pho-todurcissable qui peut être diluée et lavée à l'eau comprenant un composé de type amine tertiaire comportant au moins une insaturation éthylénique et étant utilisé sous forme neutralisée par un acide carboxylique, un amorceur de photopolymérisation, un diluant et une résine époxyde, caractérisée en ce que ladite résine époxyde y est incorporée dans des proportions allant de 2 à 15 équivalents par équivalent dudit acide carboxylique utilisé pour ladite neutralisation.

**2.** Composition conforme à la revendication 1, qui comprend une composition d'une résine photosensible contenant un composé de type amine tertiaire comportant au moins une insaturation éthylénique, un amorceur de photopolymérisation et un diluant, ledit composé de type amine tertiaire étant neutralisé avec un acide carboxylique, et une composition d'une résine thermodurcissable contenant une résine époxyde en des proportions allant de 2 à 15 équivalents par équivalent dudit acide carboxylique utilisé pour ladite neutralisation du composé de type amine tertiaire.

**3.** Composition conforme à la revendication 1 ou 2, dans laquelle ledit composé de type amine tertiaire possède un indice d'amine compris entre 35 et 150 mg KOH/g.

**4.** Composition conforme à une quelconque des revendications 1 à 3, dans laquelle ledit composé de type amine tertiaire est obtenu en effectuant une réaction d'addition d'une amine secondaire sur une partie des insaturations éthyléniques d'un composé ayant au moins deux insaturations éthyléniques.

**5.** Composition conforme à la revendication 4, dans laquelle ledit composé de type amine secondaire est choisi dans l'ensemble formé par des amines secondaires aliphatiques et des imidazoles à fonction amine

secondaire, et ledit composé ayant au moins deux insaturations éthyléniques est un composé choisi dans l'ensemble formé par des (méth)acrylates polyfonctionnels, des époxy-(méth)acrylates et des époxyuréthanes-(méth)acrylates.

6. Composition conforme à une quelconque des revendications 1 à 5, dans laquelle ledit acide carboxylique est un acide monocarboxylique qui est hydrophile et capable de réagir avec ledit composant de type résine époxyde.

7. Composition conforme à une quelconque des revendications 1 à 6, dans laquelle ledit acide carboxylique est utilisé dans des proportions comprises entre 0,8 et 2 équivalents par équivalent d'amine contenue dans ledit composé de type amine tertiaire.

8. Composition conforme à une quelconque des revendications 1 à 7, dans laquelle ladite résine époxyde est au moins un des éléments de l'ensemble formé par les résines époxydes solubles dans l'eau et les résines époxydes dispersibles dans l'eau.

9. Composition conforme à une quelconque des revendications 1 à 8, dans laquelle l'amorceur de photopolymérisation est au moins un composé choisi dans l'ensemble formé par la benzoïne et les éthers d'alkyle de celle-ci, les acétophénones, les anthraquinones, les cétals, les benzophénones et les xanthones et est utilisé dans des proportions comprises entre 1 et 30 parties en poids pour 100 parties en poids dudit composé de type amine tertiaire.

10. Composition conforme à une quelconque des revendications 1 à 9, dans laquelle ledit diluant est de l'eau et/ou un solvant organique.

11. Composition conforme à une quelconque des revendications 1 à 10, qui contient en outre au moins un additif choisi dans l'ensemble formé par des monomères photopolymérisables, des composés macromoléculaires, des agents tensio-actifs, des charges inorganiques, des pigments de coloration, des inhibiteurs de thermopolymérisation, des agents épaississants, des agents anti-mousse, des agents nivelants, des agents de couplage et des agents anti-oxydants.

12. Procédé pour la formation d'un masque de soudure à base de résist, caractérisé en ce que l'on applique une composition de revêtement liquide photodurcissable et thermodurcissable décrite dans une quelconque des revendications 1 à 11 sur une plaquette à circuits imprimés, en ce que l'on sèche ensuite au préalable la composition de revêtement conférant ainsi un caractère hydrophobe au film de revêtement, en ce que l'on expose de façon sélective le film de revêtement à un rayonnement actinique, en ce que l'on développe le film de revêtement à l'aide d'une solution aqueuse diluée d'acide formant ainsi dans celui-ci un motif, et en ce que l'on chauffe ensuite le film formant le motif afin de le thermodurcir.

13. Procédé conforme à la revendication 12, dans lequel ladite application de la composition sur la plaquette de circuits intégrés est effectuée par un procédé de sérigraphie, de revêtement au rideau, de revêtement par pulvérisation ou de revêtement au rouleau.

14. Procédé conforme à la revendication 12 ou 13, dans lequel ladite solution aqueuse diluée d'acide est une solution aqueuse contenant un acide inorganique, un acide carboxylique, un acide sulfonique ou un ester acide d'acide phosphorique à une concentration comprise entre 0,5 et 3% en poids.

15. Procédé conforme à une quelconque des revendications 12 à 14, dans lequel ledit séchage préalable est effectué à une température comprise entre 60 et 100°C et ledit chauffage du film formant le masque, après développement, est effectué à une température comprise entre 140 et 180°C.

16. Montage d'une plaquette à circuits imprimés, constitué d'une plaquette à circuits imprimés sur laquelle est formé un circuit et d'un film formant un masque constitué d'un produit durci obtenu à partir de la composition conforme à la revendication 1 et superposé selon un motif prédéfini sur la plaquette à circuits imprimés.

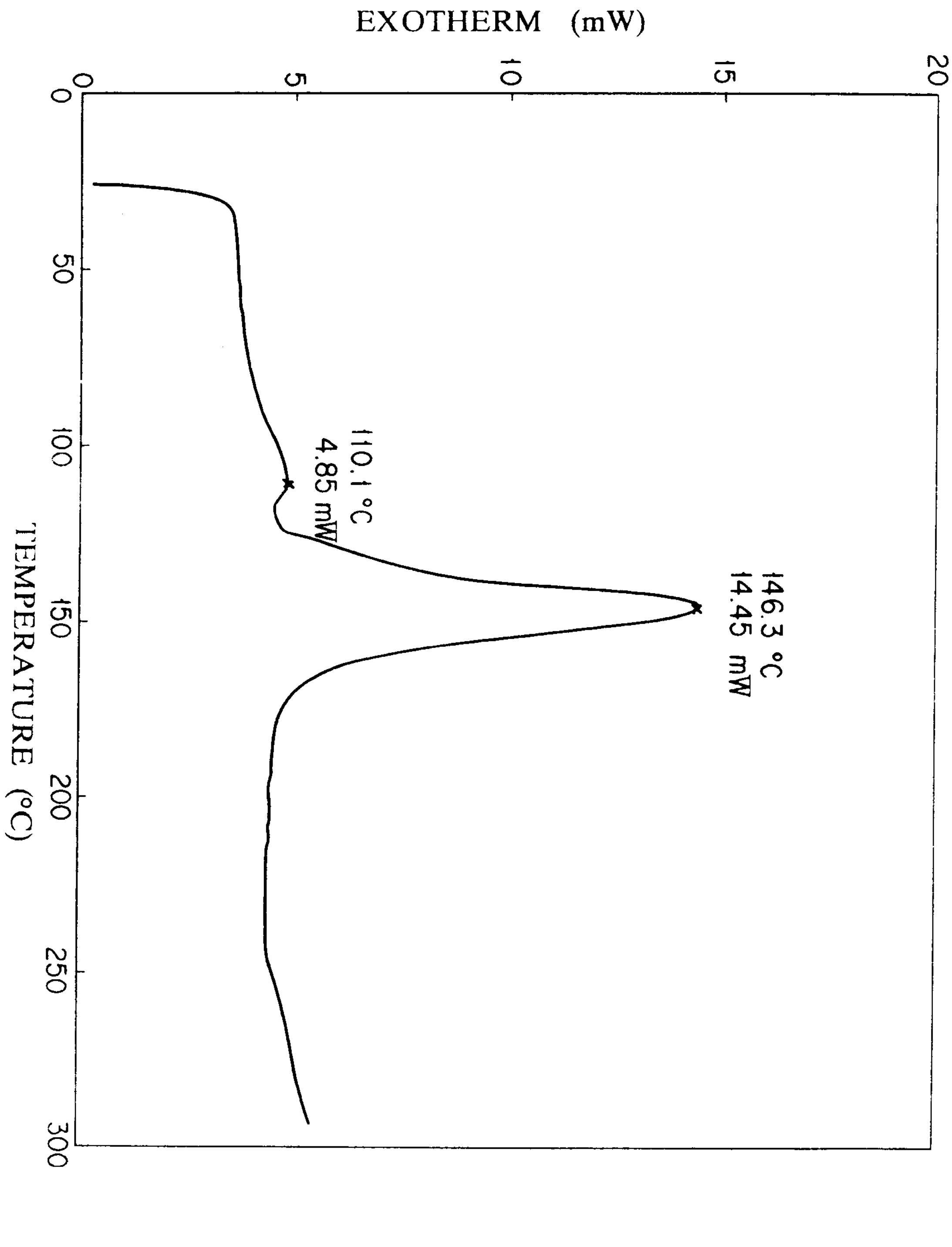
EXOTHERM (mW)
0
5
10
15
20
0
50
100
150
200
250
300
110.1 °C
4.85 mW
146.3 °C
14.45 mW
TEMPERATURE (°C)